# EUROPEAN PATENT APPLICATION

(11) **EP 3 640 997 A1**
(43) Date of publication of application: **22.04.2020**
(21) Application number: 18828195.0
(22) Date of filing: 17.05.2018
(51) Int. Cl.: H01L 31/048

(54) **PACKAGING STRUCTURE AND METHOD OF FILM PHOTOVOLTAIC COMPONENT**

(30) Priority: 07.07.2017 CN 201710549144
(71) Applicant: Hangzhou Microquanta Semiconductor Corporation Limited, Hangzhou, Zhejiang 311121 (CN)
(72) Inventor: LIU, Ming, Hangzhou, Zhejiang 311121 (CN); YAN, Buyi, Hangzhou, Zhejiang 311121 (CN); YAO, Jizhong, Hangzhou, Zhejiang 311121 (CN)
(74) Representative: Sun, Yiming
(86) International application number: PCT/CN2018/087357
(87) International publication number: WO 2019/007155

(57) **Abstract**

Related is a thin-film photovoltaic module packaging structure, including back glass, a perovskite solar cell, an upper packaging adhesive film, front glass and a packaging adhesive. The upper packaging adhesive film (EVA and POE and so on) are disposed at a lower surface of the front glass, and the perovskite solar cell is disposed with a front surface facing upward at a lower surface of the upper packaging adhesive film, and the back glass is disposed under the perovskite solar cell. The packaging adhesive is coated at a side surface of the upper packaging adhesive film and between a back surface of the perovskite solar cell and the back glass. The packaging adhesive is butyl rubber. The butyl rubber is coated on the entire back surface of the perovskite solar cell to protect the perovskite solar cell. Further, for each layer of material of the perovskite solar cell, the packaging adhesive made of butyl rubber is an inert material, the cost of which is lower than a material such as EVA. The butyl rubber has a strong anti-infiltration capability, leading to a good effect.

## Description

### TECHNICAL FIELD

The present disclosure relates to the field of photovoltaic technology, and in particular to a thin-film photovoltaic module packaging structure and a method thereof.

### BACKGROUND

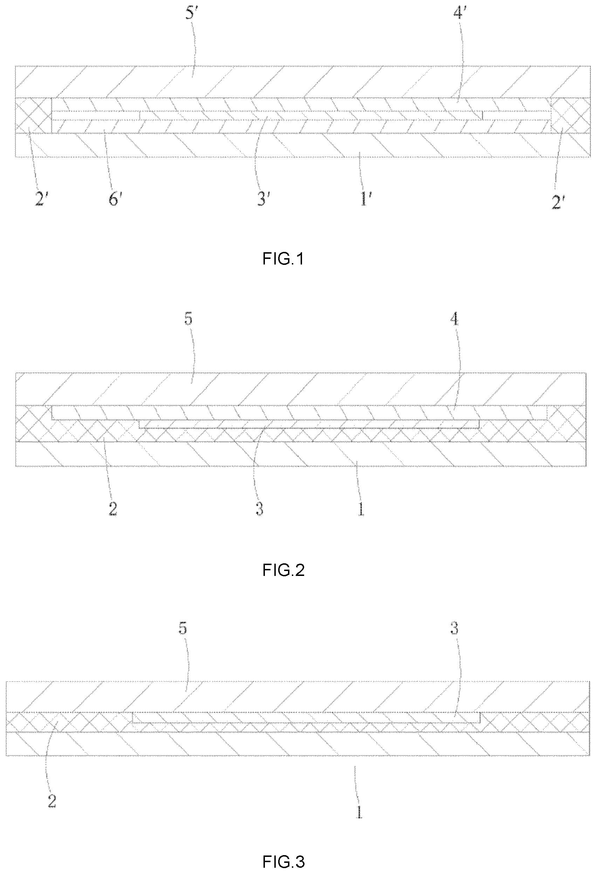

At present, a perovskite solar cell usually has a packaging structure as shown in FIG. 1. The packaging structure of the perovskite solar cell sequentially includes back glass 1', a lower packaging adhesive film 6', a perovskite solar cell 3', an upper packaging adhesive film 4' and front glass 5' from bottom to top. Since the perovskite solar cell 3' has a particular thickness (usually 1-2 mm), large gaps will be left at edge positions of the packaged perovskite solar cell 3'. Generally, a sealant 2' such as UV adhesive and silicone resin are placed at these positions. The existing packaging adhesives (such as EVA and POE) and their combinations all cannot satisfy requirements of the international standard IEC61215: 2016 regarding a stability test of a solar cell because the existing packaging adhesive has excessively high water vapor permeability, and cannot satisfy requirements of a perovskite material for water vapor blocking. After the water vapor permeates through the packaging adhesive, the water vapor reacts with perovskite substance in the perovskite solar cell 3', disabling the decomposition of the perovskite substance.

### SUMMARY

To solve the above technical problems, the present disclosure provides a thin-film photovoltaic module packaging structure and a method thereof to further improve its packaging technology and enhance anti-aging and anti-infiltration capabilities.

The present disclosure is achieved by providing a thin-film photovoltaic module packaging structure including back glass, a perovskite solar cell, an upper packaging adhesive film, front glass and a packaging adhesive. The perovskite solar cell is smaller in shape than the back glass and the front glass, the upper packaging adhesive film is disposed at a lower surface of the front glass, the perovskite solar cell is disposed with a front surface facing upward at a lower surface of the upper packaging adhesive film, the back glass is disposed under the perovskite solar cell, the packaging adhesive is coated at side surfaces of the perovskite solar cell and the upper packaging adhesive film and between a back surface of the perovskite solar cell and the back glass. The packaging adhesive is butyl rubber.

The present disclosure is achieved by further providing a thin-film photovoltaic module packaging structure including back glass, front glass and a perovskite solar cell growing at a surface of the front glass and a packaging adhesive. The perovskite solar cell is disposed between the back glass and the front glass, the back glass is disposed under the perovskite solar cell, the packaging adhesive is coated at the lower surface and a side surface of the perovskite solar cell. The packaging adhesive is butyl rubber.

Further, the packaging adhesive has a thickness of 0.2 mm to 1.5 mm.

Further, the back glass and the front glass are any one of ultra-white low-iron tempered glass, low-iron patterned tempered glass, semi-tempered glass, coated glass, TPT glass, TPE glass and PET glass respectively.

The present disclosure is achieved by further providing a packaging method of the thin-film photovoltaic module packaging structure as described above. The method includes the following steps.

At step 1, the front glass is placed on a working table, the upper packaging adhesive film and the perovskite solar cell are sequentially placed on the front glass from bottom to top, where a front surface of the perovskite solar cell faces downward.

At step 2, the packaging adhesive is coated on a back surface of the perovskite solar cell, where an outer edge of the packaging adhesive is smaller than an outer edge of the front glass.

At step 3, the back glass is placed on the packaging adhesive to form a stacked structure.

At step 4, the stacked structure is placed into a encapsulator, and the encapsulator is started to package the perovskite solar cell between the back glass and the front glass.

The present disclosure may be achieved by further providing a packaging method of the thin-film photovoltaic module packaging structure as described above. The method includes the following steps.

At step 1, the front glass containing the perovskite solar cell growing on a surface of the front glass is placed on a working table, the packaging adhesive is coated on a back surface of the perovskite solar cell, where an outer edge of the packaging adhesive is smaller than an outer edge of the front glass.

At step 2, the back glass is placed on the packaging adhesive to form a stacked structure.

At step 3, the stacked structure is placed into a encapsulator, and the encapsulator is started to package the perovskite solar cell between the back glass and the front glass.

Further, starting the encapsulator includes heating the encapsulator to 50°C-130°C and starting a vacuuming device to completely exhaust air within a chamber where the stacked structure is located.

According to the thin-film photovoltaic module packaging structure and the method thereof in the present disclosure, the upper packaging adhesive film and the packaging adhesive are disposed around and on the side surface of the perovskite solar cell to protect the perovskite solar cell. Further, for each layer of material of the perovskite solar cell, the packaging adhesive made of a butyl rubber is an inert material that does not react with the material of the perovskite solar cell, and a material cost of the butyl rubber is lower than that of a traditional photovoltaic material such as EVA. Further, the butyl rubber has low water vapor permeability and strong anti-infiltration capability. Thus, compared with the prior art, the present disclosure achieves a very good effect.

### BRIEF DESCRIPTION OF THE DRAWINGS

FIG. 1 is a schematic diagram illustrating a section of a thin-film photovoltaic module packaging structure in the prior art.
FIG. 2 is a schematic diagram illustrating a section of a thin-film photovoltaic module packaging structure according to a preferred example of the present disclosure.
FIG. 3 is a schematic diagram illustrating a section of a thin-film photovoltaic module packaging structure according to another preferred example of the present disclosure.

### DETAILED DESCRIPTION OF THE EMBODIMENTS

To describe the technical problems to be solved, technical solutions and beneficial effects of the present disclosure more clearly, the present disclosure will be further described in detail below in combination with accompanying drawing and examples. It is to be understood that the specific examples described herein are merely illustrative of the present disclosure and are not intended to limit the present disclosure.

FIG. 2 illustrates a thin-film photovoltaic module packaging structure according to a preferred example of the present disclosure. The thin-film photovoltaic module packaging structure includes back glass 1, a perovskite solar cell 3, an upper packaging adhesive film 4, front glass 5 and a packaging adhesive 2.

The shape of the perovskite solar cell 3 is smaller than those of the back glass 1 and the front glass 5. The upper packaging adhesive film 4 is disposed at a lower surface of the front glass 5, the perovskite solar cell 3 is disposed with a front surface (i.e., a light-receiving working surface) facing upward at a lower surface of the upper packaging adhesive film 4, and the back glass 1 is disposed under the perovskite solar cell 3. The packaging adhesive 2 is coated at a side surface of the upper packaging adhesive film 4 and between a back surface of the perovskite solar cell 3 and the back glass 1. The packaging adhesive 2 is butyl rubber.

The above structure form is referred to as "a three-glass assembly" for short, that is, the structure includes the back glass 1, the front glass 5 and glass sandwiched with the perovskite solar cell.

FIG. 3 illustrates a thin-film photovoltaic module packaging structure according to another preferred example of the present disclosure. The thin-film photovoltaic module packaging structure includes back glass 1, a perovskite solar cell 3, front glass 5 and a packaging adhesive 2. The perovskite solar cell 3 is directly grown on a surface of the front glass 5. The perovskite solar cell 3 is disposed between the back glass 1 and the front glass 5, the back glass 1 is disposed under the perovskite solar cell 3, and the packaging adhesive 2 is coated at the lower surface and a side surface of the perovskite solar cell 3. The packaging adhesive 2 is butyl rubber.

The above structure form is referred to as "a double-glass assembly" for short, that is, the structure includes the back glass 1 and the front glass 5, where the perovskite solar cell directly grows on the front glass 5.

In the above examples of the thin-film photovoltaic module packaging structure, the packaging adhesive 2 has a thickness of 0.2 mm to 1.5 mm. The back glass 1 and the front glass 5 are any one of ultra-white low-iron tempered glass, low-iron patterned tempered glass, semi-tempered glass, coated glass, TPT glass, TPE glass and PET glass respectively.

The present disclosure is achieved by further providing an example of a packaging method of the thin-film photovoltaic module packaging structure as described above. The method includes the following steps.

At step 1, the front glass 5 is placed on a working table, and the upper packaging adhesive film 4 and the perovskite solar cell 3 are sequentially placed on the front glass 5 from bottom to top, where a front surface of the perovskite solar cell 3 faces downward.

At step 2, the packaging adhesive 2 is coated on a back surface of the perovskite solar cell 3, where an outer edge of the packaging adhesive 2 is smaller than an outer edge of the front glass 5.

At step 3, the back glass 1 is placed on the packaging adhesive 2 to form a stacked structure.

At step 4, the stacked structure is placed into a encapsulator, and the encapsulator is started to package the perovskite solar cell 3 between the back glass 1 and the front glass 5.

The present disclosure is achieved by further providing an example of a packaging method of another thin-film photovoltaic module packaging structure as described above. The method includes the following steps.

At step 1, the front glass 5 containing the perovskite solar cell 3 growing on a surface of the front glass 5 is placed on a working table, and the packaging adhesive 2 is coated on a back surface of the perovskite solar cell 3, where an outer edge of the packaging adhesive 2 is smaller than an outer edge of the front glass 5.

At step 2, the back glass 1 is placed on the packaging adhesive 2 to form a stacked structure.

At step 3, the stacked structure is placed into a encapsulator, and the encapsulator is started to package the perovskite solar cell 3 between the back glass 1 and the front glass 5.

In the above packaging method examples, starting the encapsulator includes heating the encapsulator to 50°C-130°C and starting a vacuuming device to completely exhaust air within a chamber where the stacked structure is located.

The water blocking effect of the butyl rubber is far better than a traditional packaging adhesive film, such as EVA and polyolefin (POE), and the butyl rubber is only covered on the back surface of the perovskite solar cell 3 without leading to a problem of light blocking.. Therefore, in the present disclosure, the back surface and edge portions of the perovskite solar cell 3 are packaged by adopting the butyl rubber instead of the packaging adhesive film, such as EVA and POE. No matter whether one cell is sandwiched by two pieces of glass or one piece of glass is covered on another piece of glass containing the perovskite solar cell growing on the surface of the another piece of glass, the packaging adhesive film (such as EVA and POE), or the like is covered on an active region of a corresponding perovskite solar cell 3, and then, the sealant such as the butyl rubber is used to seal up the entire back surface.

Contents of the present disclosure will be further described below in combination with examples.

### Example 1

At step 1, colored tempered glass (i.e., the front glass 5) is placed on the working table, and the EVA upper packaging adhesive film 4 and the perovskite solar cell 3 are sequentially placed on the colored tempered glass from bottom to top, where the front surface of the perovskite solar cell 3 faces downward.

At step 2, black butyl rubber is coated on the back surface of the perovskite solar cell 3, where an outer edge of the black butyl rubber is smaller than an outer edge of the above colored tempered glass.

At step 3, back tempered glass (i.e., the back glass 1) is placed on the black butyl rubber to form a stacked structure.

At step 4, the stacked structure is placed into the encapsulator, and the encapsulator is started to be heated to 150°C with a difference of upper and lower pressures being 0.9 atmospheric pressures and pressurized for 200 seconds to complete encapsulation.

### Example 2

At step 1, ordinary ITO tempered glass (i.e., the front glass 5) with the perovskite solar cell 3 growing on a surface of the ITO tempered glass is placed on the working table with a perovskite-containing side facing upward.

At step 2, black butyl rubber is coated on the back surface of the perovskite solar cell 3, where an outer edge of the black butyl rubber is smaller than an outer edge of the ordinary ITO tempered glass.

At step 3, back tempered glass (i.e., the back glass 1) is placed on the black butyl rubber to form a stacked structure.

At step 4, the stacked structure is placed in the encapsulator, and the encapsulator is started to be heated to 100°C with a difference of upper and lower pressures being 0.7 atmospheric pressures and pressurized for 200 seconds to package the perovskite solar cell 3 between the back tempered glass and the ordinary ITO tempered glass.

The above descriptions are only the preferred examples of the present disclosure and are not intended to limit the present disclosure. Any modifications, equivalent substitutions and improvements and the like made within the spirit and scope of the present disclosure should be included within the scope of protection of the present disclosure.

## Claims

1. A thin-film photovoltaic module packaging structure, comprising back glass (1), a perovskite solar cell (3), an upper packaging adhesive film (4), front glass (5) and a packaging adhesive (2), wherein a shape of the perovskite solar cell (3) is smaller than shapes of the back glass (1) and the front glass (5), the upper packaging adhesive film (4) is disposed at a lower surface of the front glass (5), the perovskite solar cell (3) is disposed with a front surface facing upward at a lower surface of the upper packaging adhesive film (4), the back glass (1) is disposed under the perovskite solar cell (3), the packaging adhesive (2) is coated at a side surface of the upper packaging adhesive film (4) and between a back surface of the perovskite solar cell (3) and the back glass (1), and the packaging adhesive (2) is butyl rubber.

2. A thin-film photovoltaic module packaging structure, comprising back glass (1), front glass (5) and a perovskite solar cell (3) growing on a surface of the front glass (5) and a packaging adhesive (2), wherein the perovskite solar cell (3) is disposed between the back glass (1) and the front glass (5), the back glass (1) is disposed under the perovskite solar cell (3), the packaging adhesive (2) is coated at the lower surface and a side surface of the perovskite solar cell (3), and the packaging adhesive (2) is butyl rubber.

3. The thin-film photovoltaic module packaging structure according to claim 1 or 2, wherein the packaging adhesive (2) has a thickness of 0.2 mm to 1.5 mm.

4. The thin-film photovoltaic module packaging structure according to claim 1 or 2, wherein the back glass (5) and the front glass (1) are any one of ultra-white low-iron tempered glass, low-iron patterned tempered glass, semi-tempered glass, coated glass, TPT glass, TPE glass and PET glass respectively.

5. A packaging method of the thin-film photovoltaic module packaging structure according to claim 1, comprising the following steps:
at step 1, placing the front glass (5) on a working table, and sequentially placing the upper packaging adhesive film (4) and the perovskite solar cell (3) on the front glass (5) from bottom to top, wherein a front surface of the perovskite solar cell (3) faces downward;
at step 2, coating the packaging adhesive (2) on a back surface of the perovskite solar cell (3), wherein an outer edge of the packaging adhesive (2) is smaller than an outer edge of the front glass (5);
at step 3, placing the back glass (1) on the packaging adhesive (2) to form a stacked structure; and
at step 4, placing the stacked structure in a encapsulator, and starting the encapsulator to package the perovskite solar cell (3) between the back glass (1) and the front glass (5).

6. A packaging method of the thin-film photovoltaic module packaging structure according to claim 2, comprising the following steps:
at step 1, placing the front glass (5) containing the perovskite solar cell (3) growing on a surface of the front glass (5) on a working table, and coating the packaging adhesive (2) on a back surface of the perovskite solar cell (3), wherein an outer edge of the packaging adhesive (2) is smaller than an outer edge of the front glass (5);
at step 2, placing the back glass (1) on the packaging adhesive (2) to form a stacked structure; and
at step 3, placing the stacked structure into a encapsulator, and starting the encapsulator to package the perovskite solar cell (3) between the back glass (1) and the front glass (5).

7. The packaging method of the thin-film photovoltaic module packaging structure according to claim 5 or 6, wherein starting the encapsulator comprises heating the encapsulator to 50°C-130°C and starting a vacuumizing device to completely exhaust air within a chamber where the stacked structure is located.
